# EUROPÄISCHE PATENTSCHRIFT

(11) **EP 1 176 644 B1**
(45) Veröffentlichungstag und Bekanntmachung des Hinweises auf die Patenterteilung: **19.12.2007**
(21) Anmeldenummer: 00115995.3
(22) Anmeldetag: 26.07.2000
(51) Int. Cl.: H01L 31/18, H01L 31/072

(54) **Verfahren zum Aktivieren von CdTe-Dünnschichtsolarzellen**
Method to activate CdTe thin film solar cells
Méthode d'activation de cellules solaires en CdTe à couches minces

(43) Veröffentlichungstag der Anmeldung: 30.01.2002
(73) Patentinhaber: ANTEC Solar Energy AG, 60311 Frankfurt am Main (DE)
(72) Erfinder: Campo, Dr. Manuel Dieguez, 63457 Hanau (DE); BONNET, Dr. Dieter, 61381 Friedrichsdorf (DE); GEGENWART, Dr. Rainer, 63322 Rödermark (DE); BEIER, Dr. Jutta, 65719 Hofheim (DE)
(74) Vertreter: Englaender, Klaus

(56) Entgegenhaltungen:
- US-A- 4 735 909
- MCCANDLESS B E ET AL: "Vapor phase treatment of CdTe/CdS thin films with CdCl/sub 2/:O/sub 2/" CONFERENCE RECORD OF THE TWENTY FIFTH IEEE PHOTOVOLTAIC SPECIALISTS CONFERENCE - 1996, WASHINGTON, DC, USA, 13-17 MAY 1996, Seiten 781-784, XP000896986 1996, New York, NY, USA, IEEE, USA ISBN: 0-7803-3166-4
- QU Y ET AL: "HCl vapor post-deposition heat treatment of CdTe/CdS films" CONFERENCE RECORD OF THE TWENTY FIFTH IEEE PHOTOVOLTAIC SPECIALISTS CONFERENCE - 1996, WASHINGTON, DC, USA, 13-17 MAY 1996, Seiten 1013-1016, XP000897019 1996, New York, NY, USA, IEEE, USA ISBN: 0-7803-3166-4
- D. BONNET: "Status of CdTe Solar Cells" 14TH EUROPEAN PHOTOVOLTAIC SOLAR ENERGY CONFERENCE, 30. Juni 1997 (1997-06-30) - 4. Juli 1997 (1997-07-04), Seiten 2688-2693, XP002156160 Barcelona, ES
- ZHOU T X ET AL: "VAPOR CHLORIDE TREATMENT OF POLYCRYSTALLINE CDTE/CDS FILMS" WORLD CONFERENCE ON PHOTOVOLTAIC ENERGY,US,NEW YORK, IEEE, Bd. CONF. 1, 5. Dezember 1994 (1994-12-05), Seiten 103-106, XP000681263
- PATENT ABSTRACTS OF JAPAN vol. 1998, no. 05, 30. April 1998 (1998-04-30) & JP 10 004205 A (MATSUSHITA DENCHI KOGYO KK), 6. Januar 1998 (1998-01-06)

## Beschreibung

Die Erfindung betrifft ein Verfahren zum Aktivieren von CdTe-Dünnschichtsolarzellen, in welchem die mit der CdTe-Schicht versehenen Substrate bei erhöhter Temperatur einem HCl haltigen Gasgemisch ausgesetzt werden.

Die Aktivierung von CdTe-Dünnschichtsolarzellen wird seit etlichen Jahren erfolgreich mit CdCl₂ durchgeführt. Dabei kann es sich um CdTe/CdS-Dünnschichtsolarzellen handeln, wie sie in der EP 0 535 522 A2 offenbart sind und für die Untersuchungen der vorliegenden Erfindung zugrunde gelegt wurden. Gemäß der EP 0 535 522 A2 erfolgt die Schichtabscheidung durch das CSS-Verfahren und die nach Aufbringen der CdTe-Schicht vorgenommene Aktivierung wird bei erhöhter Temperatur um 400 °C bevorzugt in gasförmigem CdCl₂ und bei reduziertem Druck durchgeführt. Das Arbeiten mit gasförmigem CdCl₂ ist allerdings infolge der Wasserlöslichkeit der Cadmiumverbindung mit hohen Sicherheitsauflagen verbunden.

Man hat daher bereits versucht, statt der Aktivierung mit gasförmigem CdCl₂ gasfömiges HCl oder Chlorgas einzusetzen. Die Resultate waren jedoch noch nicht befriedigend und es traten Schwierigkeiten in Form unerwünschter Niederschläge auf. In dem Bericht "Processing & Modeling Issues for Thin Film Solar Cell Devices", Annual Report to National Renewable Energy Laboratory under Subcontract No. XAV-3-13170-01, Januar 1995, Birkmire et al des Institute of Energy Conversion, University of Deleware, ist ausgeführt, daß bei Einleiten von HCl-Gas mit einem Argon- oder Argon/Sauerstoffträgergas mit 4 % HCl/96 % Ar bzw. 4 % HCl/48 % Ar/48 % O₂ bessere elektrische Eigenschaften unter gleichzeitiger Verwendung von Sauerstoff erzielt wurden. Allerdings mußte bei der Behandlung mit 4 % HCl/48 % Ar/48 % O₂ eine sich bei der Aktivierung mit 400 °C Substrattemperatur bildende chlorhaltige Oberflächenabscheidung abgewaschen werden. In einer späteren Veröffentlichung desselben Instituts zu den durchgeführten Versuchen mit HCl (Proc: 25te PVSC, Mai 13 bis 17, 1996, Washington D.C., Meyers et al, Institute of Energy Conversion, University of Delaware, "HCl Vapor Post-Deposition Heat Treatment of CdTe/CdS Films") ist wiederum auf die sich bei Sauerstoffzusatz bildenden Niederschläge in Form von CdCl₂ hingewiesen. Diese dominierten gegenüber anderen Effekte wie der Sauerstoffdotierung. Man verzichtete deshalb hier auf den Sauerstoffzusatz und verwendete nur Argon als Trägergas. Nach dieser Veröffentlichung wurde ferner eine erhebliche Abhängigkeit des Wirkungsgrades der Zellen in Abhängigkeit von der HCl-Konzentration bezogen auf die Argonkonzentration festgestellt, wobei sich bessere Werte für höhere HCl-Konzentrationen ab 5 % ergaben.

Daneben wurde mit einer HCl/Stickstoffgasmischung gearbeitet (Proc: 1te WCPEC, Dezember 5 bis 9, 1994, Hawai, T. X. Zhou et al, Solar Cells Inc., "Vapor Chloride Treatment of Polycrystalline CdTe/CdS Films"). Die HCl/Stickstoffgasmischung wurde dadurch erzeugt, daß man Stickstoffgas durch ein Gefäß mit konzentrierter Salzsäurelösung perlen ließ. Für 0,25 cm²-Solarzellen, die einer Behandlung mit der so erzeugten Gasmischung unterzogen wurden, wurde bei einer Substrattemperatur von 400 °C ein Wirkungsgrad von 8,4 % ermittelt. Auch für zehnminütige Behandlungen mit einer vergleichbaren vorgemischten HCl/Stickstoffgasmischung und großflächigen Beschichtungen wurde dieser Wirkungsgrad ermittelt. Bei verdünnter Gasmischung aus Chlor und Stickstoff wurden zwar lokal in einzelnen Schichtbereichen höhere Wirkungsgrade zwischen 9 und 10 % beobachtet, jedoch ist diese Art Aktivierung als kritischer dargestellt.

Das Dokument "Vapor phase treatment of CdTe/CdS thin films with CdCl2:O2", MacCandless et al., Conference record of the 25th IEEE Photovoltaic Specialists Conference - 1996, WASHINGTON, DC, USA, 13-17 MAY 1996, Seiten 781-784, 1996, New York, NY, USA, IEEE, USA ISBN: 0-7803-3166-4 beschreibt ein weiteres Verfahren zur Aktivierung von CdTe Schichten in einem CdCl₂/Ar/O₂ Gasgemisch.

Das Dokument "Status of CdTe Solar Cells", D. BONNET, 14th European Photovoltaic Solar Energy Conference, 30. Juni 1997 - 4. Juli 1997, Seiten 2688-2693, Barcelona, beschreibt ein Verfahren zur Aktivierung von von CdTe Schichten. Die Dünnschichtsolarzellen werden mit Lösungen von CdCl₂ in Methanol im Nassverfahren beaufschlagt, getrocknet und in Luft getempert.

Der vorliegenden Erfindung liegt die Aufgabe zu Grunde, ein möglichst effizientes, kostengünstiges Aktivierungsverfahren für CdTe-Dünnschichtsolarzellen anzugeben, mit dem hohe Wirkungsgrade erzielbar sind.

Diese Aufgabe wir durch den Gegenstand der unabhängigen Ansprüche gelöst. Vorteilhafte Weiterbildungen sind in den Unteransprüchen definiert.

In der Erfindung wird ein HCl, Sauerstoff- sowie auch Stickstoff haltiges Gasgemisch mit einem unter Atmosphärendruck liegenden Gesamtdruck für die Aktivierung verwendet. In zahlreichen Versuchsketten für Gasgemische unterschiedlicher Zusammensetzungen wurde einerseits gefunden, daß für eine solche Gasmischung bei einem sehr niedrigen HCl-Partialdruckanteil zwischen 0,002 und 0,2 % vom Gesamtgasdruck für einen weiten Bereich unterschiedlicher Stickstoff- und Sauerstoffkonzentrationen sehr hohe Wirkungsgrade von angenähert 12 % und teilweise über 12 % erreicht werden. Der bevorzugte Bereich mit den beobachteten höchsten Wirkungsgraden liegt bei einem HCl-Partialdruckanteil zwischen 0,05 und 0,15 %, d.h. um 0,1 %.

Andererseits kann gemäß Anspruch 2 bei einem eingestellten Sauerstoff-Partialdruckanteil auf Werte zwischen etwa 5 und 25 % vom Gesamtgasdruck die HCl-Konzentration in weiten Bereichen von den angegegeben sehr niedrigen Werten auf über 20 % Partialdruck gesteigert werden, ohne daß der Wirkungsgrad unter 11 % abfällt. Wirkungsgrade mit über 12 % sind bei dem so begrenzten Sauerstoff-Partialdruckanteil noch bis etwa 2 % HCl-Partialdruckanteil ohne weiteres erzielbar. Wird hingegen mit spürbar höherem Sauerstoffanteilen gearbeitet, so ergeben sich diese Wirkungsgrade nur für die erwähnten besonders niedrigen HCl-Partialdruckwerte gemäß Anspruch 1.

Die Tatsache, daß diese Ergebnisse analytisch noch nicht beschrieben sind, schmälert nicht die durch sie eröffneten Verfahrensvorteile. So ist die Erzielung derart hoher Wirkungsgrade mit den angegebenen geringen und geringsten HCl-Anteilen in Stickstoff und Sauerstoff in mehrfacher Hinsicht für die Realisierung eines für die Massenaktivierung von Solarzellenmodulen geeigneten Verfahrens geradezu sensationell. So kann einerseits das Aktivierungsgas durch Auswaschen sehr einfach vom HCl befreit werden. Andererseits sind die möglichen HCl-Konzentrationen so gering, daß die Sicherheitsmaßnahmen auf ein Minimum reduziert werden können.

Ferner war so gut wie keine Ätzung der CdTe-Oberfläche nachweisbar.

Zudem ist der Wirkungsgrad relativ unabhängig von Schwankungen der HCl-Konzentration, die auch bei hohen Sauerstoffgehalten zwischen 0,002 und 0,2 % HCl-Partialdruck, d.h. über zwei Zehnerpotenzen variieren können. Daher sind keine aufwendigen Regelungen für den HCl-Partialdruck erforderlich.

Wenn dann noch der Sauerstoff-Partialdruck auf einen Wert um 20 % gesetzt wird, ist der Wirkungsgrad praktisch unabhängig von jedweden Schwankungen der HCl-Konzentration. Dies bedeutet aber nichts anderes, als daß Luft unter reduziertem Druck mit völlig unschädlichen und zudem nicht genau einzustellenden geringsten und bezüglich Konzentrationsschwankungen unkritischen HCl-Gaszusätzen zur erfolgreichen Aktivierung der Zellen eingesetzt werden kann und dabei Wirkungsgrade über 12 % erzielbar sind. Damit sind effiziente, kostengünstige, umweltfreundliche und ungiftige Aktivierungsverfahren möglich.

Beim Arbeiten unter den in den unabhängigen Ansprüchen aufgezeigten Bedingungen wurden in sämtlichen der zahlreichen Experimente keinerlei Niederschläge und kein Residuum auf den CdTe-Schichten beobachtet. Ob dies eine unmittelbare Folge des eingestellten Unterdrucks war, ist ungeklärt, zumal, wie im folgenden und weiter unten aufgezeigt, der Druck über einen weiten Bereich variiert werden konnte.

Der Gesamtdruck wird vorzugsweise auf Werte über 100 mbar eingestellt. In den Versuchsreihen erwiesen sich Gesamtdruckwerte um 500 mbar als zweckmäßig, zumal bereits bei deutlich niedrigeren Drücken durch eine weitere Steigerung des Drucks keine positiven Auswirkungen auf den Wirkungsgrad mehr beobachtet werden konnten. 600 mbar kann als eine auch im Hinblick auf den Gasverbrauch vernünftige Obergrenze für den Gesamtdruck angesehen werden.

Die Aktivierung erfolgt bevorzugt mit Durchfluß der Gasmischung durch eine Aktivierungskammer, in der die Substrate in an sich bekannter Weise auf die gewünschte Aktivierungstemperatur erwärmt werden. Anschließend wird die Gasmischung nach anfänglichem Aufbau des Gasdrucks so im Durchfluß gehalten, daß der anfängliche Druck im Verlaufe der Aktivierungsdauer nicht steigt.

Es war jedoch auch möglich, in einer Kammer ohne Gasdurchfluß zunächst z.B. einen Gesamtgasdruck von 500 mbar einzustellen, der sich in den folgenden 15 oder 20 Minuten infolge der Ausdehnung des Gases wegen des heißen Substrats langsam auf bis zu 800 mbar erhöhte. Hierbei konnte keine Beeinträchtigung des Wirkungsgrades beobachtet werden. Dies zeigt auch , wie robust das erfindungsgemäße Verfahren ist.

Die Substrattemperatur sollte im Hinblick auf einen möglichst hohen Wirkungsgrad auf Werte über 370 °C eingestellt werden. In den Versuchsreihen wurden sehr gute Wirkungsgrade zwischen 390 und 420 °C erzielt. Dies zeigt, daß auch die Substrattemperatureinstellung nicht kritisch ist. Werte von 500 °C oder mehr werden nicht bevorzugt, zumal die im erfindungsgemäßen Verfahren bevorzugt eingesetzten Zellen ein kostengünstiges Floatglassubstrat aufweisen.

Die Aktivierung wird bevorzugt in 1 bis 15 Minuten durchgeführt. Grundsätzlich kann man hierbei durch Erhöhen der Substrattemperatur die Aktivierungszeit vermindern. Wenn man keinen besonders hohen Wirkungsgrad benötigt, kann die Aktivierungszeit bei Temperaturen über 450 °C bedarfsweise auf minimale Zeiten im Bereich von 15 Sekunden reduziert werden.

Soll nicht mit einer bezüglich der Sauerstoff/Stickstoffzusammensetzung luftähnlichen Mischung gearbeitet werden, so werden der Stickstoff-Partialdruckanteil bevorzugt auf Werte über 20 % , der Sauerstoff-Partialdruckanteil auf Werte unter 60 % und der HCl-Partialdruckanteil auf Werte unter 0,15 % festgelegt, bei denen besonders hohe Wirkungsgrade auch bei erhöhtem Sauerstoffpartialdruck erzielt werden konnten.

Ein mögliches Ausführungsbeispiel, bei dem ein Wirkungsgrad von über 12 % erzielt wird, beinhaltet die folgenden Verfahrensparameter:

| | |
|---|---|
| Substrattemperatur: | 390 °C |
| Gesamtdruck: | 500 mbar |
| Sauerstoff-Partialdruck: | etwa 20 % |
| Stickstoff-Partialdruck: | etwa 80 % |
| HCl-Partialdruck: | etwa 0,1 % |

Hierzu wurde Luft durch Filter gereinigt und der entsprechende Unterdruck mit Hilfe eines Nadelventils eingestellt. Das HCl-Gas wurde aus einer Gasflasche ebenfalls über ein Nadelventil in die Kammer geleitet. Ferner verfügte die Kammer über Pumpvorrichtungen und mehrere Druckmeßgeräte. Das Substrat wurde auf einem Substrathalter fixiert und mit Halogenstrahlern im Vakuum aufgeheizt, bevor mit der Gaseinleitung begonnen wurde. Das Substrat war gemäß der EP 0 535 522 A2 ein Floatglassubstrat, das mit einer TCO-Schicht, einer CdS-Schicht und einer CdTe-Schicht beschichtet war. Das Substrat wurde zwischen 10 und 15 Minuten mit dem obigen Gasgemisch aktiviert. Für die Messung der Strom-/Spannungskennlinie und die Bestimmung von Füllfaktor und Wirkungsgrad wurden die aktivierten Proben standardmäßig geätzt, mit Rückkontakt versehen und in mehrere Zellen strukturiert, und daraufhin in einer Meßanordnung mit simuliertem Sonnenlicht bestrahlt. Es ergaben sich folgende Werte:
Wirkungsgrad: 12,1 %
Füllfaktor: 71,1 %
Kurzschlußstrom: 21,6 mA/cm²
Leerlaufspannung: 790 mV.

In den weiteren Versuchsreihen wurden Sauerstoff und Stickstoff aus Gasflaschen entnommen. Es wurde für alle Versuchsreihen stets der Wirkungsgrad ermittelt. Variiert wurden nicht nur die Zusammensetzung der Gasmischung, sondern auch der Gesamtdruck, die Substrattemperatur und die Aktivierungszeit.

Im wesentlichen wurden hier die folgenden bevorzugten Parameter für einen möglichst guten Wirkungsgrad ermittelt:

Bei Sauerstoff-Partialdrücken zwischen 5 und etwa 25 % ist der Wirkungsgrad weitgehend unabhängig vom HCl-Partialdruck. Wirkungsgrade um 11 % konnten bei einem beliebigen HCl-Partialdruck bis über 30 % durchgängig erzielt werden. Jedoch werden auch hier die Wirkungsgrade besser bei kleinerem HCl-Partialdruck ab etwa 2 % und weniger. So konnte bei 22 % Sauerstoff-Partialdruck (110 mbar bei einem Gesamtdruck 500 mbar) ab einem HCl-Partialdruck von 2 % (10 mbar) und weniger ein Wirkungsgrad von 12 % und mehr bis zu geringsten Werten des HCl-Partialdrucks erzielt werden. Bei Vergleichsmessungen mit einem Sauerstoff-Partialdruck von 60 % und mehr wurden derart hohe Wirkungsgrade jedoch nur noch mit einem HCl-Partialdruck von etwa 0,1 % und weniger bei ansonsten gleichen Bedingungen erzielt. Bei höheren HCl-Partialdrücken nahm der Wirkungsgrad mit zunehmendem HCl-Anteil zunächst langsam, dann deutlicher ab. Bei noch höheren Sauerstoffanteilen verlief der Abfall des Wirkungsgrades mit zunehmendem HCl-Anteil ab etwa 0,2 % HCl-Partialdruck (1 mbar, wobei hier der Wirkungsgrad noch angenähert 10 % betrug) noch steiler als beim Sauerstoff-Partialdruck von 60 %.

Diese Tendenzen werden auch durch Meßreihen bestätigt, in denen Sauerstoff- und HCl-Konzentrationen über weite Bereiche geändert wurden. Diese Meßreihen zeigen ein bevorzugtes Verhältnis von p(HCl)/p(O₂) zwischen 0,001 und 0,1 auf. Absolut zeigten sich die besseren Ergebnisse bei Sauerstoff-Partialdrücken ab etwa 18 % und darüber sowie für einen HCl-Partialdruck von 1 % und weniger.

Für das oben angegebene Beispiel mit der luftähnlichen Zusammensetzung ergab sich, daß ab etwa 390 °C und bis zu etwa 420 °C Substrattemperatur der Wirkungsgrad über 12 % lag.

Ab etwa 100 mbar Gesamtdruck wurde eine deutliche Zunahme des Wirkungsgrades festgestellt, der bei weiterer Steigerung des Gesamtdrucks schnell eine Sättigung erreichte.

## Patentansprüche

1. Verfahren zum Aktivieren von CdTe-Dünnschichtsolarzellen, in welchem die mit der CdTe-Schicht versehenen Substrate bei einer Substrattemperatur zwischen 370°C und 500°C einem HCl, Sauerstoff und Stickstoff enthaltenden Gasgemisch mit einem unter Atmosphärendruck liegenden Gesamtdruck ausgesetzt werden und der HCl-Partialdruckanteil des Gasgemisches auf Werte zwischen 0,002 und 0,2 % vom Gesamtgasdruck eingestellt wird.

2. Verfahren zum Aktivieren von CdTe-Dünnschichtsolarzellen, in welchem die mit der CdTe-Schicht versehenen Substrate bei einer Substrattemperatur zwischen 370°C und 500°C einem HCl, Sauerstoff und Stickstoff enthaltenden Gasgemisch mit einem unter Atmosphärendruck liegenden Gesamtdruck ausgesetzt werden und der Sauerstoff-Partialdruckanteil des Gasgemisches auf Werte zwischen 5 und 25 % vom Gesamtgasdruck eingestellt wird.

3. Verfahren nach Anspruch 1 oder 2,
**dadurch gekennzeichnet,**
**dass** der Gesamtdruck auf Werte über 100 mbar und vorzugsweise unter 600 mbar eingestellt wird.

4. Verfahren nach einem der vorhergehenden Ansprüche,
**dadurch gekennzeichnet,**
**dass** die Substrattemperatur zwischen 390 und 420 °C eingestellt wird.

5. Verfahren nach einem der vorhergehenden Ansprüche,
**dadurch gekennzeichnet,**
**dass** die Gasmischung aus Luft unter Zusatz von HCl-Gas und Einstellung eines Unterdrucks erzeugt wird.

6. Verfahren nach einem der vorhergehenden Ansprüche,
**dadurch gekennzeichnet,**
**dass** die Aktivierung in 1 bis 15 Minuten durchgeführt wird.

7. Verfahren nach Anspruch 1 und nach einem der auf Anspruch 1 rückbezogenen Ansprüche 1 bis 4 und 6,
**dadurch gekennzeichnet,**
**dass** der Stickstoff-Partialdruckanteil auf Werte über 20 % und der Sauerstoff-Partialdruckanteil auf Werte unter 60 % eingestellt werden.

8. Verfahren nach Anspruch 2 und nach einem der auf Anspruch 2 rückbezogenen Ansprüche 1 bis 6,
**dadurch gekennzeichnet,**
**dass** der HCl-Partialdruckanteil auf Werte zwischen 0,002 und 2 % eingestellt wird.

9. Verfahren nach einem der vorhergehenden Ansprüche,
**dadurch gekennzeichnet,**
**dass** der HCl-Partialdruckanteil auf Werte zwischen 0,05 und 0,15 % eingestellt wird.

## Claims

1. Method for the activation of CdTe thin film solar cells, in which the substrates provided with the CdTe layer are subjected, at a substrate temperature between 370°C and 500°C, to a gas mixture containing HCl, oxygen and nitrogen with a total pressure lying below atmospheric pressure, and the HCl partial pressure component of the gas mixture is set to values between 0.002 and 0.2% of the total gas pressure.

2. Method for the activation of CdTe thin film solar cells, in which the substrates provided with the CdTe layer are subjected, at a substrate temperature between 370°C and 500°C, to a gas mixture containing HCl, oxygen and nitrogen with a total pressure lying below atmospheric pressure, and the oxygen partial pressure component of the gas mixture is set to values between 5 and 25% of the total gas pressure.

3. Method according to Claim 1 or 2, **characterized in that** the total pressure is set to values above 100 mbar and preferably below 600 mbar.

4. Method according to one of the preceding claims, **characterized in that** the substrate temperature is set between 390 and 420°C.

5. Method according to one of the preceding claims, **characterized in that** the gas mixture is produced from air with the addition of HCl and the establishment of a negative pressure.

6. Method according to one of the preceding claims, **characterized in that** the activation is carried out in 1 to 15 minutes.

7. Method according to Claim 1 and according to one of the Claims 1 to 4 and 6 referring back to Claim 1, **characterized in that** the nitrogen partial pressure component is set to values above 20% and the oxygen partial pressure component is set to values below 60%.

8. Method according to Claim 2 and according to one of the Claims 1 to 6 referring back to Claim 2, **characterized in that** the HCl partial pressure component is set to values between 0.002 and 2%.

9. Method according to one of the preceding claims, **characterized in that** the HCl partial pressure component is set to values between 0.05 and 0.15%.

## Revendications

1. Procédé d'activation de cellules solaires en couches minces de CdTe, dans lequel des substrats munis de la couche de CdTe sont exposés à une température de substrat comprise entre 370°C et 500°C à un mélange gazeux contenant du HCl, de l'oxygène et de l'azote sous une pression totale inférieure à la pression atmosphérique et la fraction de pression partielle de HCl du mélange gazeux est réglée à des valeurs comprises entre 0,002 et 0,2 % de la pression totale du gaz.

2. Procédé d'activation de cellules solaires en couches minces de CdTe, dans lequel les substrats munis de la couche de CdTe sont exposés à une température de substrat comprise entre 370°C et 500°C à un mélange gazeux contenant du HCl, de l'oxygène et de l'azote sous une pression totale inférieure à la pression atmosphérique et la fraction de pression partielle d'oxygène du mélange gazeux est réglée à des valeurs comprises entre et 5 et 25 % de la pression totale du gaz.

3. Procédé selon la revendication 1 ou 2, **caractérisé en ce que**,
on règle la pression totale à des valeurs supérieures à 100 mbar et de préférence inférieures à 600 mbar.

4. Procédé selon l'une quelconque des revendications précédentes, **caractérisé en ce que**
on règle la température de substrat à des valeurs comprises entre 390 et 420 °C.

5. Procédé selon l'une quelconque des revendications précédentes, **caractérisé en ce que**,
on crée le mélange gazeux à partir d'air, en additionnant du gaz HCl et en établissant une dépression.

6. Procédé selon l'une quelconque des revendications précédentes, **caractérisé en ce que**,
on procède à l'activation pendant 1 à 15 minutes.

7. Procédé selon la revendication 1 et selon l'une quelconque des revendications 1 à 4 et 6, lorsque dépendante de la revendication 1, **caractérisé en ce que**,
on règle la fraction de pression partielle d'azote à des valeurs supérieures à 20 % et la fraction de pression partielle d'oxygène à des valeurs inférieures à 60 %.

8. Procédé selon la revendication 2 et selon l'une quelconque des revendications 1 à 6 lorsque dépendante de la revendication 2, **caractérisé en ce que**,
on règle la fraction de pression partielle du HCl à des valeurs comprises entre 0,002 et 2 %.

9. Procédé selon l'une quelconque des revendications précédentes, **caractérisé en ce que**,
on règle la fraction de pression partielle du HCl à des valeurs comprises entre 0,05 et 0,15 %.
